# EUROPÄISCHE PATENTSCHRIFT

(11) **EP 3 080 837 B1**
(45) Veröffentlichungstag und Bekanntmachung des Hinweises auf die Patenterteilung: **11.06.2025**
(21) Anmeldenummer: 14830366.2
(22) Anmeldetag: 26.11.2014
(51) Int. Cl.: H01L 21/67

(54) **VERFAHREN UND VORRICHTUNG ZUM BEHANDELN VON GEGENSTÄNDEN MIT EINEM MEDIUM, INSBESONDERE EINER FLÜSSIGKEIT**
METHOD AND DEVICE FOR TREATING OBJECTS WITH A MEDIUM, EN PARTICULIER LIQUID
PROCÉDÉ ET DISPOSITIF POUR LE TRAITEMENT D'OBJETS PAR UN MILIEU, EN PARTICULIER UN LIQUIDE

(30) Priorität: 09.12.2013 AT 9462013
(43) Veröffentlichungstag der Anmeldung: 19.10.2016
(73) Patentinhaber: 4Tex GmbH, 9500 Villach (AT)
(72) Erfinder: HOFER-MOSER, Jörg, 9500 Villach (AT); LINDER, Manuel, 9500 Villach (AT); SMOLINER, Klaus, 9500 Villach (AT)
(74) Vertreter: Beer & Partner Patentanwälte KG
(86) Internationale Anmeldenummer: PCT/AT2014/000209
(87) Internationale Veröffentlichungsnummer: WO 2015/085334

(56) Entgegenhaltungen:
- US-A- 5 478 435
- US-A- 5 965 813
- US-A- 6 092 542
- US-A1- 2007 183 775
- US-A1- 2012 276 749
- US-B1- 6 376 013

## Beschreibung

Die Erfindung betrifft ein Verfahren zum Behandeln von Gegenständen mit einem Medium, insbesondere einer Flüssigkeit und weiters eine Vorrichtung, mit welcher das erfindungsgemäße Verfahren durchgeführt werden kann.

Beim Behandeln von Gegenständen mit einem Medium, insbesondere einer Flüssigkeit stellt sich das Problem, dass die Temperatur, die Konzentration und/oder die Menge an Flüssigkeit, die auf die zu behandelnde Fläche des Gegenstandes aufgebracht wird, je nach den jeweils herrschenden Gegebenheiten geändert werden muss. Dabei kann es erforderlich sein, die Temperatur, die Konzentration und/oder die Menge an Flüssigkeit während des Behandelns der Fläche des Gegenstandes zu ändern, um diese entsprechend von Unterschieden in der Struktur und/oder dem Aufbau des Gegenstandes zu ändern. Dieses Problem stellt sich beispielsweise beim Ätzen von Halbleiter-Wafern und beim Reinigen von geätzten Halbleiter-Wafern.

Das Ätzen von Halbleiter-Wafern mit Ätzmedien (Ätzflüssigkeiten) erfolgt in der Regel dadurch, dass ein Ätzmedium auf den auf einer Halterung angeordneten und durch die Halterung in Drehung versetzten Halbleiter-Wafer aufgebracht wird.

Die derzeit verwendeten Einrichtungen zum Ätzen von Halbleiter-Wafern sind hinsichtlich der Regelung der Temperatur der Ätzflüssigkeit zu träge, um die Temperatur während des Prozesses schnell zu ändern oder schnell auszuregeln.

Durch die im Stand der Technik verwendeten, trägen (Ätz-)Vorrichtungen ist es ausschließlich möglich, die Temperatur der Ätzflüssigkeit stabil zu halten. Ein aktiver Einfluss auf die Gleichmäßigkeit der Temperatur ist im Stand der Technik nicht möglich. Dadurch ergibt sich keine gleichmäßige Temperaturverteilung am Halbleiter-Wafer, was die Gleichmäßigkeit des Ergebnisses des Ätzens verschlechtert.

Des Weiteren ergibt sich das Problem, dass im derzeitigen Stand der Technik am Beginn des Ätzvorganges (Einschaltvorgang) auf die zu behandelnde Fläche des Gegenstandes (Halbleiter-Wafer) aufgebrachtes Ätzmedium kälter ist als dies für einen ordnungsgemäßen Bearbeitungsvorgang erforderlich ist.

Erst nach einiger Zeit sind alle mediumführenden Teile im thermischen Gleichgewicht.

US 6,376,013 B1 offenbart ein Verfahren zum Behandeln von Gegenständen mit einem Medium mit den Schritten: Aufbringen des Mediums auf die zu behandelnde Fläche des Gegenstandes mit Hilfe einer Aufbringeeinrichtung, die relativ zu dem zu behandelnden Gegenstand über die zu behandelnde Fläche des Gegenstandes bewegt wird; Regeln von Eigenschaften des auf den zu behandelnden Gegenstand auszubringenden Mediums in Abhängigkeit von der Lage der Aufbringeeinrichtung relativ zu der zu behandelnden Fläche des Gegenstandes und Regeln der Temperatur des auf den zu behandelnden Gegenstand auszubringenden Mediums, wobei die Temperatur mit Hilfe eines Temperatursensors, welcher der Aufbringeeinrichtung zugeordnet ist, erfasst wird. US 6,376,013 B1 offenbart weiters eine Vorrichtung zum Behandeln von Gegenständen mit einer Halterung für den zu behandelnden Gegenstand, mit einer Einrichtung zum Aufbringen des Mediums auf den zu behandelnden Gegenstand, zu welcher Einrichtung eine Leitung für das Medium führt, und mit einem Aktor zum Bewegen der Aufbringeeinrichtung relativ zu den zu behandelnden Gegenstand, wobei ein Sensor zum Erfassen von wenigstens einer Eigenschaft des Medium und ein Regelkreis, der funktionell mit einem Sensor verbunden ist, vorgesehen ist, mit einer der Leitung für das Medium zugeordneten Einrichtung zum Regeln der in der Zeiteinheit durch die Leitung strömende Menge an Medium, welche Einrichtung mit dem Regelkreis funktionell verbunden istund mit einem Sensor, welcher der Aufbringeeinrichtung an der Stelle des Austrittes des Mediums aus ihr zugeordnet ist und welcher die Temperatur des Mediums erfasst.

Der Erfindung liegt die Aufgabe zugrunde, ein Verfahren und eine zum Ausführen des Verfahrens geeignete Vorrichtung vorzuschlagen, mit der während des Behandelns eines Gegenstandes (z. B. Wafer) die Temperatur und/oder die Konzentration und/oder die Menge der Flüssigkeit beliebig geändert werden kann, um Unterschiede in der Struktur des zu behandelnden Gegenstandes, insbesondere Gleichmäßigkeitsunterschiede, in der Oberfläche eines Halbleiter-Wafers, auszugleichen.

Gelöst wird diese Aufgabe erfindungsgemäß mit einem Verfahren, das die Merkmale von Anspruch 1 aufweist.

Soweit die Vorrichtung betroffen ist, wird die der Erfindung zugrundeliegende Aufgabe mit einer Vorrichtung gelöst, welche die Merkmale des unabhängigen, auf die Vorrichtung gerichteten Anspruchs aufweist.

Bevorzugte und vorteilhafte Ausgestaltungen der Erfindung sind Gegenstand der Unteransprüche.

Durch das erfindungsgemäße Verfahren wird in seinen Ausführungsformen erreicht, dass die Gleichmäßigkeit des Ergebnisses der Behandlung des Gegenstandes, insbesondere die Gleichmäßigkeit über die Oberfläche des Halbleiter-Wafers verbessert wird, weil es möglich ist, die Temperatur und/oder die Menge des auf den Gegenstand aufgebrachtem Behandlungsmedium anzupassen. So ergibt sich eine Verringerung von Ausschuss, da eine Steigerung der Qualität erreicht wird.

Des Weiteren erlaubt es die Erfindung in vorteilhafter Weise kleinere Strukturen zu behandeln.

Des Weiteren entfällt bei dem erfindungsgemäßen Verfahren ein ständiges Aufheizen des Mediums, insbesondere der Flüssigkeit auf die benötigte Temperatur, so dass Energie eingespart werden kann.

In einer Ausführungsform der Erfindung wird durch induktives Aufheizen des Medium (Flüssigkeit), das zur Behandlung des Gegenstandes verwendet wird, die Möglichkeit eröffnet, kleine Heizelemente zu verwenden, so dass zu temperierende Massen verringert werden. Durch Induktionsheizung wird ein Aufheizen lediglich an der Materialoberfläche erreicht, so dass Wärme durch Konvektion übertragen werden kann. Dies ergibt ein rasches Reagieren auf beim Ausführen des Verfahrens erforderliche Änderungen der Temperatur des Medium.

Da das zum Behandeln eingesetzte Medium (Flüssigkeit) allenfalls gekühlt werden muss, kann ein Kühler verwendet werden, der beispielsweise mit Peltier-Elementen arbeitet. Diese PeltierElemente können sowohl heizend als auch kühlend eingesetzt werden, sodass die Dynamik der erfindungsgemäßen Verfahrensweise und Vorrichtung verbessert ist.

Des Weiteren erlaubt es die Erfindung in Ausführungsformen durch einen Durchflussregler, die Menge an in der Zeiteinheit der Aufbringeeinrichtung, insbesondere deren Düse, zugeführte Menge an Medium (Flüssigkeit) zu regeln, also den Durchfluss des Medium zu ändern. Dies ergibt die Möglichkeit, bei kleinem Durchfluss das Medium über einen längeren Zeitraum zu erwärmen und bei hohem Durchfluss das Medium über einen kürzeren Zeitraum zu erwärmen. Durch Koppelung dieser Prinzipien mit der örtlichen Lage der Aufbringeeinrichtung, insbesondere deren Düse, relativ zu dem zu behandelnden Gegenstand ergibt sich eine vorteilhafte Arbeitsweise beim Behandeln von Gegenständen mit einem Medium (einer Flüssigkeit), insbesondere beim Ätzen und/oder Reinigen von Halbleiter-Wafern.

Im Einzelnen erlaubt die Erfindung in Ausführungsformen eine Temperaturmanipulation von auf die Fläche des Gegenstandes aufgetragenem Medium (Flüssigkeit), wobei das Medium erwärmt oder gekühlt werden kann.

Durch Regeln der Durchflussmenge des auf die zu behandelnden Fläche aufgetragenen Medium (Flüssigkeit), insbesondere bei Halbleiter-Ätzanlagen, ergibt sich eine zusätzlich mögliche Manipulation, um die Verfahrensbedingungen an die Gegebenheiten anzupassen.

Bevorzugt erfolgt im Rahmen der Erfindung das Aufwärmen des für die Behandlung eingesetzten Medium (Flüssigkeit) durch konvektive Wärmeübertragung einer durch Induktion erwärmten, bevorzugt chemisch inerten, Oberfläche, die von dem Medium (Flüssigkeit für die Behandlung) umströmt wird. Insbesondere ist dabei die Verwendung einer Einrichtung zum Erwärmen in Form eines Durchlauferhitzers bevorzugt, da die Übertragung überwiegend durch Konvektion anstatt durch Wärmeleitung oder Wärmestrahlung erfolgt. So ergibt sich eine besonders effektive Wärmeübertragung, die ein schnelles Erwärmen des Medium (der Flüssigkeit), die für die Behandlung eingesetzt wird, erlaubt.

Bei dem erfindungsgemäßen Verfahren werden Erwärmen, Kühlen und Regeln der Durchflussmenge mit Einrichtungen ausgeführt, die der Leitung zum Zuführen des Behandlungs-Medium zur Aufbringeeinrichtung, insbesondere deren Düse, zugeordnet sind.

Weitere Einzelheiten und Merkmale der Erfindung ergeben sich aus der nachstehen Beschreibung bevorzugter Ausführungsbeispiele an Hand der Zeichnungen. Es zeigt
- Fig.1: schematisch eine Vorrichtung zum Durchführen des Verfahrens der Erfindung,
- Fig. 2: im Schnitt einen Temperatur-Sensor, der zum Erfassen der Temperatur im Bereich der Aufbringeeinrichtung eingesetzt werden kann,
- Fig. 3: den Temperatur-Sensor in auseinandergezogener Darstellung,
- Fig. 4: im Schnitt eine andere Ausführungsform eines Temperatur-Sensors,
- Fig. 5: schematisch im Schnitt eine Einrichtung zum Erwärmen der Flüssigkeit,
- Fig. 6: eine Einzelheit der Einrichtung von Fig. 5,
- Fig. 7: eine weitere Einzelheit der Einrichtung von Fig. 5,
- Fig. 8: die Einrichtung von Fig. 5 in Schrägansicht, teilweise geschnitten,
- Fig. 9: im Schnitt eine Einrichtung zum Kühlen,
- Fig. 10: eine Einrichtung zum Regeln der Durchflussmenge und
- Fig. 11: eine Anordnung zum Manipulieren der Durchflussmenge,
- Fig. 12: eine abgeänderte Ausführungsform einer Vorrichtung gemäß der Erfindung und
- Fig. 13: Kombinationen von Einrichtungen der erfindungsgemäßen Vorrichtung.

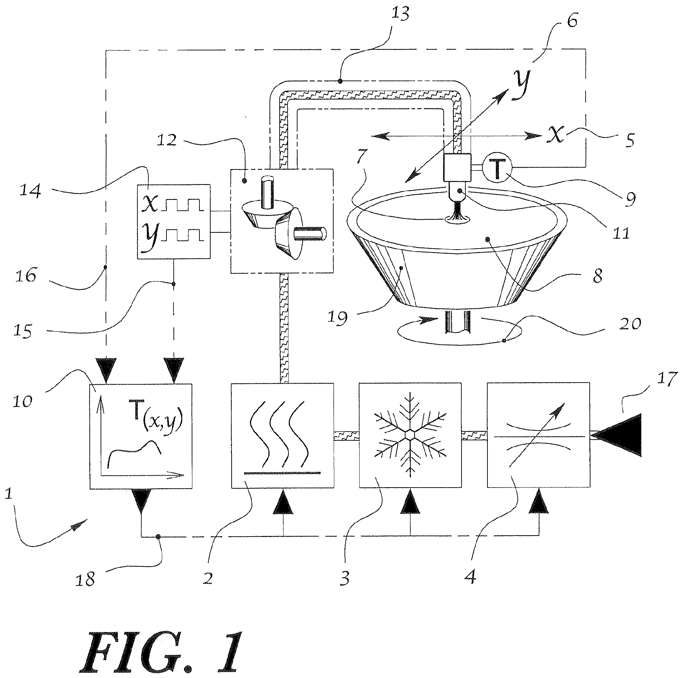

Eine in Fig. 1 gezeigte Vorrichtung 1 gemäß der Erfindung, die zum Ausführen des Verfahrens der Erfindung geeignet ist, umfasst einen Träger 19 ("chuck"), auf den ein Halbleiter-Wafer 8 aufgelegt ist. Der Träger 19 kann auf beliebige Art und Weise ausgeführt und mit einem Antrieb (nicht gezeigt) gekoppelt sein, der den Träger 19 in Drehung (Pfeil 20) versetzt.

Dem Träger 19 ist eine Einrichtung zum Aufbringen eines Behandlungs-Medium, im Beispiel einer Behandlungsflüssigkeit, zugeordnet, die eine Düse 11 umfasst, die über eine Einrichtung 13 starr mit Aktoren 12 verbunden ist. Die Aktoren 12 erlauben es, die Düse 11 der Aufbringeeinrichtung über die Einrichtung 13 relativ zur Fläche des zu behandelnden Gegenstandes, im Ausführungsbeispiel ein Halbleiter-Wafer 8, zu bewegen. Die Bewegungsmöglichkeiten in Richtung X und Richtung Y sind in Fig. 1 durch Pfeile 5 und 6 symbolisiert.

Der Düse 11 wird Behandlungsflüssigkeit, beim Ätzen von Halbleiter-Wafern ein Ätzmedium, über eine Leitung 17 zugeführt. Der Leitung 17 sind zugeordnet eine Einrichtung 4 zur Durchflussmengenregelung, eine Kühleinrichtung 3 und eine Einrichtung 2 zum Erwärmen der Flüssigkeit.

Die aktuelle Lage der Düse 11 und damit der Ort 7 des Flüssigkeitsauftrages werden durch Inkrementalgeber 14, die den Aktoren 12 zugeordnet sind, erfasst. Die Inkrementalgeber 14 geben Daten betreffend die aktuelle Lage der Auftragdüse 11 relativ zur Fläche des Wafers 8 an einen Regelkreis 10 ab.

Der Leitung 17 zum Zuführen von Behandlungs-Flüssigkeit ist unmittelbar vor der Düse 11 ein Temperatur-Sensor 9 zugeordnet, der an den Regelkreis 10 Daten betreffend die von ihm erfasste Temperatur der Flüssigkeit abgibt. Die an den Regelkreis 10 vom Temperatur-Sensor 9 abgegebenen Temperaturparameter 16 und die von den Inkrementalgebern 14 abgegebenen Positionsparameter 15 werden vom Regelkreis 10 als Regelalgorithmus den der Leitung 17 zugeordneten Einrichtungen 4 für die Durchflussmengenregelung, der Einrichtung zum Kühlen 3 und der Einrichtung 2 zum Erwärmen aufgegeben.

Auf diese Art und Weise ist eine hoch dynamische positionsgekoppelte Temperaturführung und Mengenregelung möglich, die den Vorteil einer thermischen Optimierung aller mediumführenden Teile umfasst.

Die in Fig. 1 gezeigte Vorrichtung 1 zur Temperatur- und/oder Durchflussmanipulation von der Düse 11 zugeführter Flüssigkeit arbeitet in Abhängigkeit von der Lage der Düse 11 der Aufbringeeinrichtung relativ zum behandelnden Gegenstand, im Beispiel dem Halbleiter-Wafer 8. So ist eine Verbesserung der Oberflächenregelmäßigkeit beim Reinigen und bei nasschemischem und temperaturabhängigem Ätzen, beispielsweise von Wafer-Oberflächen, erreicht.

Besonders vorteilhaft ist es, wenn im Rahmen der Erfindung als Einrichtung 2 zum Erwärmen eine Einrichtung verwendet wird, die auf Induktionsbasis arbeitet und die durch die Einrichtung 2 strömende Flüssigkeit durch Konvektion erwärmt.

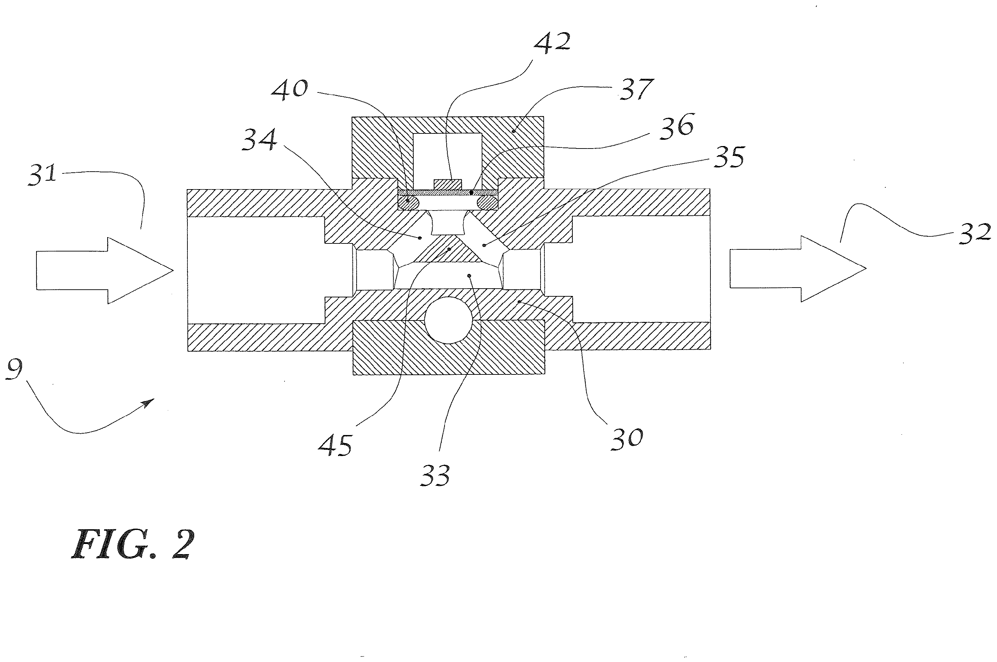

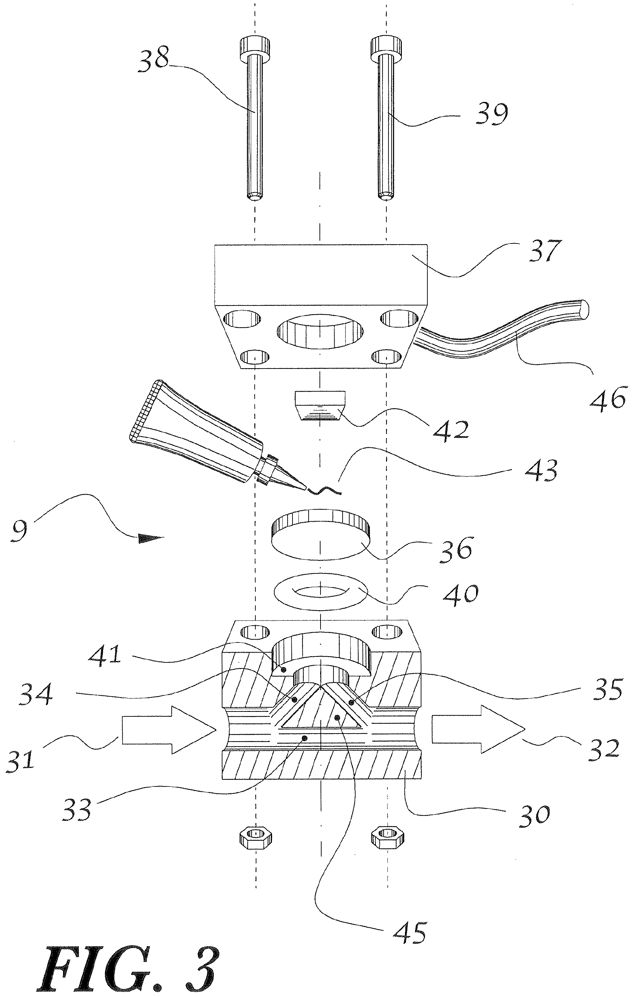

Ein Temperatur-Sensor 9, der mit der erfindungsgemäßen Vorrichtung zum Ausführen des erfindungsgemäßen Verfahrens zum Erfassen der Temperatur der auf den Gegenstand aufgebrachten Behandlungsflüssigkeit besonders geeignet ist, wird nachstehend an Hand der Fig. 2 und 3 erläutert.

Der in den Fig. 2 und 3 gezeigter Temperatur-Sensor 9 erlaubt ein schnelles Erfassen der Temperatur von Medien, wobei die Medien, insbesondere chemisch hochreaktive Gase, chemische hochreaktive Flüssigkeiten oder chemisch hochreaktive, fliessende Werkstoffe sein können. Der Temperatur-Sensor 9 ist so aufgebaut, dass der in seinen Körper 30 eintretende Medienstrom (Pfeil 31) durch einen im Strömungsweg vorgesehenen Körper 45 in zwei Teilströme aufgeteilt wird. Ein Teilstrom strömt durch einen im Wesentlichen geraden Kanal 33 und ein zweiter Teilstrom durch einen gewinkelten, zwei Abschnitte 34 und 35 umfassenden Kanal. Der durch die Kanalabschnitte 34 und 35 strömende Teilstrom trifft unter einem spitzen Winkel, von beispielsweise 45°, auf einen scheibenförmigen Körper 36 und strömt dann durch den Abschnitt 35 aus dem Körper 30 des Temperatur-Sensors 9 wieder heraus (Pfeil 32).

Durch das Aufteilen in die Teilströme ergibt sich eine Verminderung des Druckes im Bereich des Eingangs in den Temperatur-Sensor 9.

Der scheibenförmige Körper 36 wird vom Oberteil 37 des Temperatur-Sensors 9 durch Schrauben 38 und 39 über eine Dichtung 40 an eine Dichtfläche 41 des Körpers 30 des Temperatur-Sensors 9 gedrückt, so dass sich ein hermetisch geschlossenes System ergibt.

Die mediumberührenden Teile des Temperatur-Sensors 9 sind bevorzugt aus chemiebeständigen Werkstoffen, wobei beispielsweise der scheibenförmige Körper 36 vorzugsweise aus (polykristallinem) Diamant, Glaskohlenstoff, Saphir oder Silizium-Karbid, gegebenenfalls mit CVD-Beschichtung (Chemical Vapour Deposition), die Dichtung 40, vorzugsweise aus Perfluorkautschuk (FFKM), und der Körper 30 des Temperatur-Sensors 9, bevorzugt aus Polytetrafluroäthylen (PTFE), bestehen.

Das Erfassen der Temperatur im Temperatur-Sensor 9 erfolgt über einen Temperatur-Fühler 42, der beispielsweise ein Platin-Dünnschicht-Messwiderstand ist. Der Temperatur-Fühler 42 ist vorzugsweise mit Hilfe eines wärmeleitenden Klebers 43 (Zweikomponenten-Epoxy-Harz)mit dem scheibenförmigen Körper 36 verklebt, so dass ein guter Wärmeübergang gegeben ist. Von dem Temperatur-Fühler 42 führt eine Leitung 46 weg, welche die vom Temperatur-Fühler 42 erfassten Daten 16 über die in Fig. 1 gezeigte Leitung an den Regelkreis 10 abgibt.

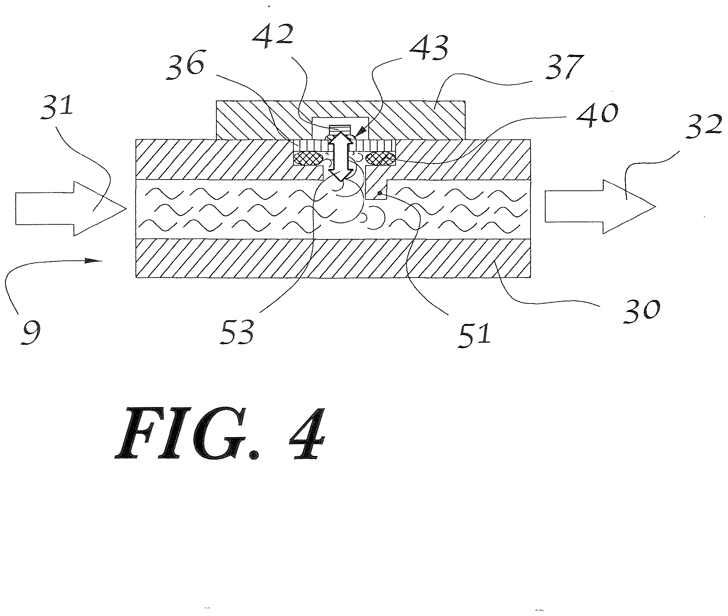

Eine andere Ausführungsform eines Temperatur-Sensors 9 ist in Fig. 4 gezeigt und wird nachstehend beschrieben.

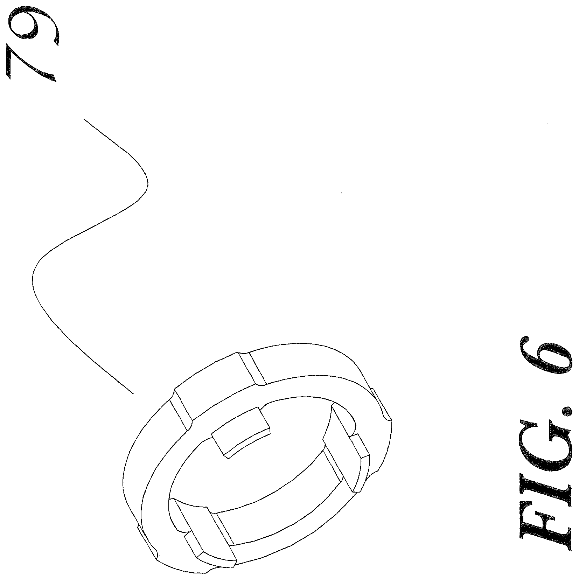

Bei dieser Ausführungsform eines Temperatur-Sensors 9 werden durch ein im Strömungskanal 11 vorgesehenes Hindernis 51 turbulente Srömungen erzwungen, die in der in Fig. 6 gezeigten Ausführungform des Temperatur-Sensors 9 einen schnellen Temperaturaustausch zwischen Scheibe 36 und Medium ergibt. So wie bei der in Fig. 2 und 2a gezeigten Ausführungsform wird die Scheibe 36 durch den Oberteil 37 des Temperatur-Sensors unter Zwischenfügen einer Dichtung 40 an die Auflagefläche 41 im Körper 30 des Temperatur-Sensors 9 gedrückt. Die in Fig. 6 gezeigte Ausführungsform eines Temperatur-Sensors 9 erlaubt ebenso wie die Ausführungsform von Fig. 2 und 2a einen raschen Temperaturaustausch zwischen durch den Temperatur-Sensor 9 strömendem Medium und dem Temperatur-Fühler 42, wie dies durch den Pfeil 53 angedeutet ist.

Der Temperatur-Sensor 9 kann auch mehrfach remanent ausgebildet sein. Hierzu sind mehrere Temperatur-Fühler 42 auf der Scheibe 36 des Temperatur-Sensors 9 aufgeklebt, deren Temperatursignale mittels eines Überprüfungsprogramms (Software Algorithmus) verglichen werden, um allenfalls auftretende Temperaturabweichungen durch Alterserscheinungen aufzuzeigen, wobei diese Temperaturunterschiede eine gewisse Differenz nicht überschreiten sollen. Ein Übersteigen der Mindest-Temperaturdifferenz wird von einem Überprüfungssystem durch ein Signal angezeigt. Ein Verändern der Temperaturdifferenz kann optisch oder akustisch angezeigt werden. Wenn mehrere Temperatur-Fühler 42 auf der Scheibe 36 angeordnet werden, ist ein mehrpoliges Kabel 46 für das Weiterleiten der Daten, welche die Temperatur-Fühler 42 erfassen, zu verwenden.

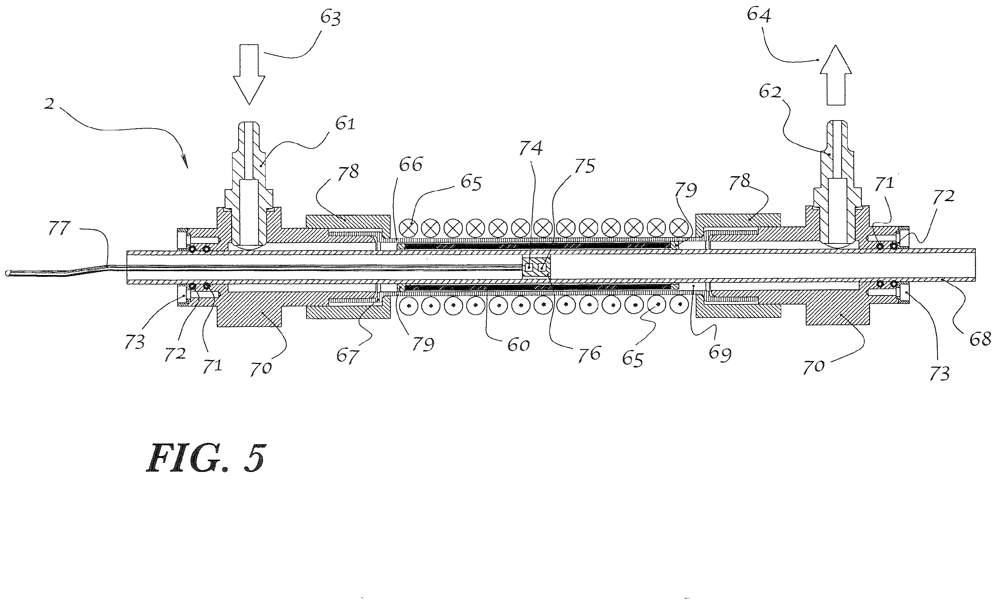

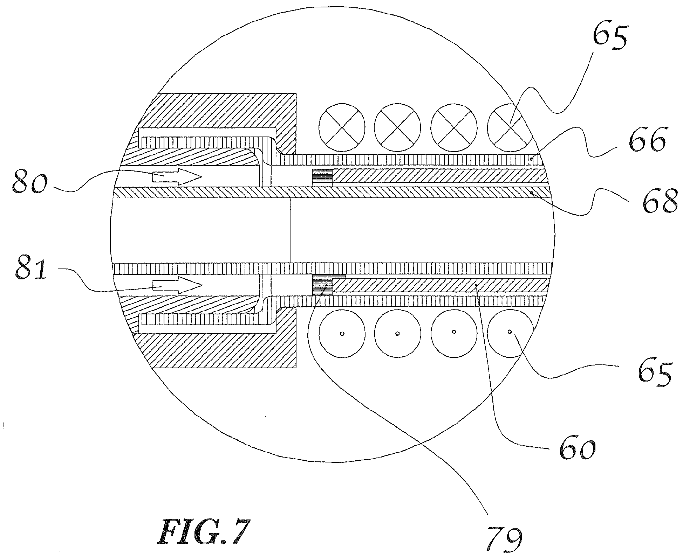

Eine auf Induktionsbasis arbeitende Einrichtung 2 zum Erwärmen von durch die Leitung 17 zur Düse 11 strömender Flüssigkeit wird nachstehend unter Bezugnahme auf die Fig. 5 bis 8 beschrieben:
Die in den Fig. 5 bis 8 gezeigte Einrichtung 2 zum Erwärmen eines flüssigen oder gasförmigen, strömenden Medium besitzt ein hohlzylinderförmiges Heizelement 60, das von dem Medium, das über Anschlüsse 61, 62 zuströmt (Pfeil 63) und abströmt (Pfeil 64), an seiner Innen- und seiner Außenseite umströmt wird. Das Heizelement 60, das beispielsweise aus Glaskohlenstoff besteht, wird durch alternierende magnetische Felder, insbesondere an seiner Außenseite erwärmt ("Skin-Effekt"). Die Frequenz des Magnetfeldes kann sich beispielsweise im Bereich von 100 kHz bis 1 MHz bewegen. Das Magnetfeld wird von einer Spule 65 erzeugt.

Die Spule 65 ist durch einen Schlauch 66, vom Heizelement 60 und vom durchströmenden Medium getrennt. Das Übertragen von Energie geht somit berührungslos vor sich, was einen beträchtlichen Vorteil gegenüber herkömmlichen Heizelementen, die einen elektrischen Kontakt benötigen und somit gegenüber dem zu behandelndem Medium abgedichtet werden müssen, bedeutet. Der Innenraum 67 ist mittels eines Innenschlauches 68 hermetisch vom Reaktorraum 69 und über ein Dichtsystem mit Körper 70, Dichtung 71, Klemmring 72 und Pressteil 73 abgetrennt. Der Pressteil 73 dient zum Einbringen von Mess-Sensoren 74 (PT 100, PT 1000) und Sicherheits-Sensoren 75 (z. B. TCO Termal Cut Off), da letztliche magnetische Energie im axialen Zentrum nur mehr minimal ist, so dass die Sensoren wegen starken elektromagnetischen Felder beschädigt werden können und einen guten Zugang zum besseren Überwachung des Heizelementes bieten. Dies für einen sicherheitsrelevanten Betrieb vorteilhaft.

Die Sensoren 74 und 75 sind vorzugsweise mittig angeordnet und in wärmeleitendem Werkstoff 76 eingebetet, wobei von den Sensoren 74, 75 Kabeln 77 abgehen. Ein aufgeweiteter Außenschlauch 20 wird mit Hilfe einer Verschraubung 78 auf den Körper 70 verpresst und bildet einen hermetisch abgedämmten Bereich vom Reaktorraum 69 zum Außenbereich.

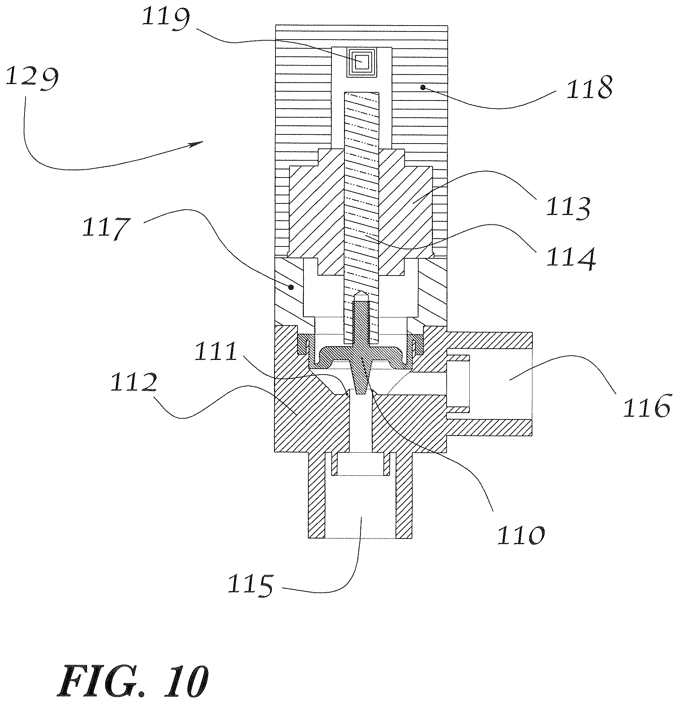

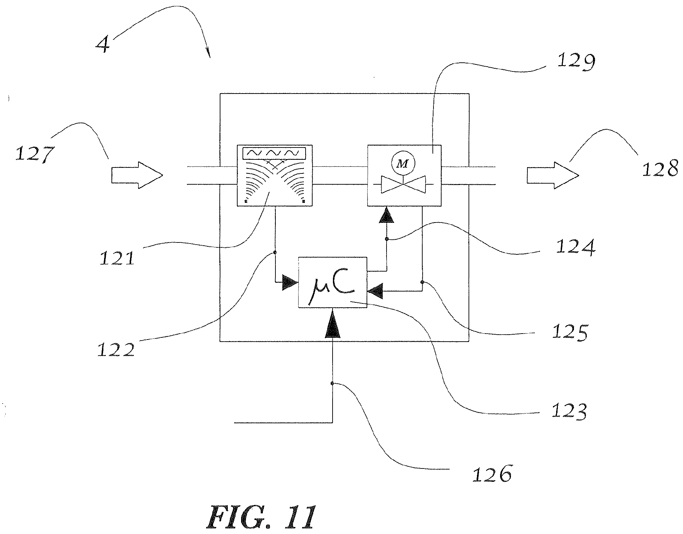

Die Einrichtung 2 ist bezüglich ihrer Mittelebene spiegelsymmetrisch, somit gilt für den Auslass 62 dasselbe wie für den Einlass 61. Auslass 62 und Einlass 61 können noch mit einem Einschrauber versehen sein. Um das Heizelement 60 auf einem gleichförmigen, konzentrischen Abstand zu dem Innenschlauch 68 und zu dem Außenschlauch 66 zu halten, wird ein Abstandsring 79 (Fig. 10 und 11) eingesetzt. Ein besonderer Vorteil ist der geringe Abstand, da sich so ein schneller Wäremübergang vom Heizelement 60 auf das Medium, das durch die Einrichtung 2 strömt, ergibt.

Das einströmende Medium wird in einen äußeren 80 und in einen inneren Strömungsbereich 81 geteilt, so dass das Heizelement 60 vollständig umströmt wird.

Die Einrichtung 2 ist so ausgelegt, dass alle Bauteile aus Werkstoffen mit eine geringer thermischer Trägheit bestehen.

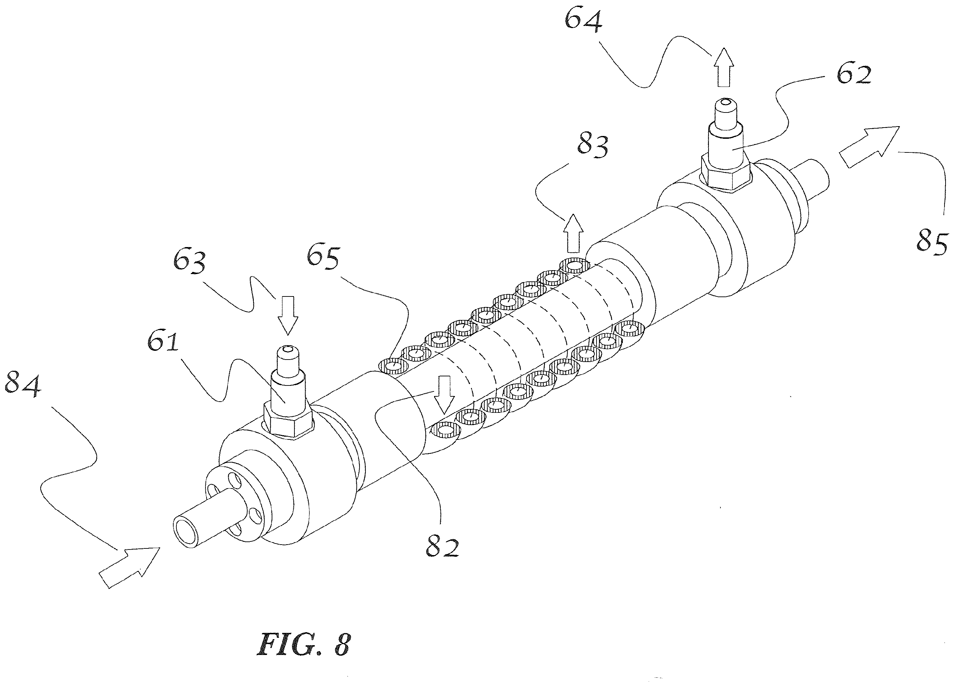

In Fig. 8 ist die Einrichtung 2 gezeigt, wobei die Spule 65, die vorzugsweise aus einem Weich-Kupfer-Rohr besteht, teilweise geschnitten in Schrägansicht dargestellt ist. Gezeigt ist in Fig. 8 auch der Eintritt 82 für eine Kühlflüssigkeit und der Austritt 83 für eine Kühlflüssigkeit, mit der die Spule 65 gekühlt wird.

Der beschriebene Aufbau der Einrichtung 2 bietet weiters die Möglich, im Innenbereich, beispielsweise durch Diffusion auftretende korrosive Gase (z. B. Fluorwasserstoff), durch Stickstoff, der über einen Spüleingang 84 eintritt und durch den Spülausgang 85 wieder austritt, wegzuspülen bzw. auszublasen.

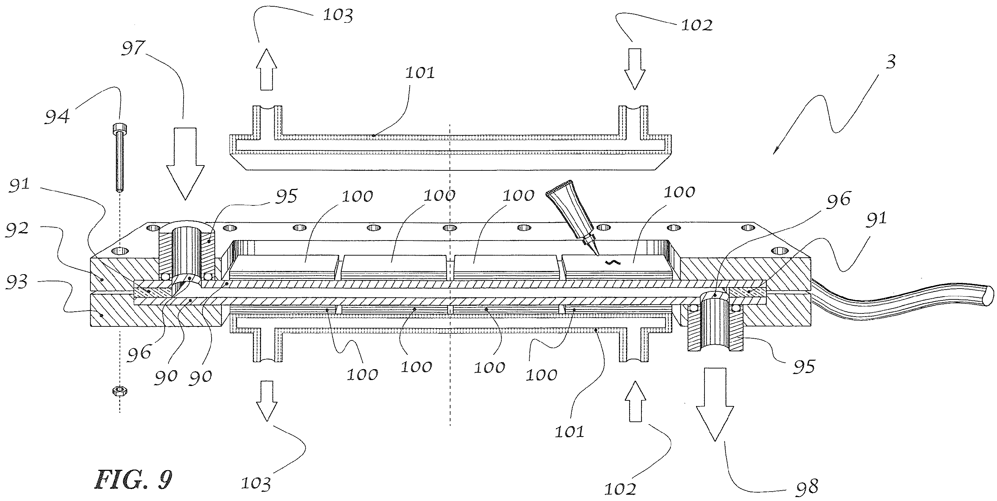

Eine Einrichtung 3 zum Kühlen wird nachstehend an Hand von Fig. 9 erläutert:
Die in Fig. 9 gezeigte Einrichtung 3 zum Kühlen von flüssigen Medien besitzt zwei übereinander und zueinder parallel ausgerichtete Platten 90. Der Raum zwischen den Platten 90 ist durch eine Randdichtung 91 abgedichtet, wobei die Dichtung 91 die Platten 90 voneinander im Abstand hält. Der Abstand der Platten 2 voneinander wird mit Vorteil so gewählt, dass ein guter Wärmeübergang auf das zu kühlendem Medium möglich ist, was durch Erreichen einer turbulenten Strömen unterstützt wird. Die Platten 90 können aus Saphir, Diamant, Glaskohlenstoff oder aus Siliziumkarbid, gegebenenfalls mit einer darauf abgeschiedenen Silizium-Karbid-Schicht (SiC), gefertigt sein.

Die Platten 2 und 3 werden zwischen einen Oberteil 92 und einem Unterteil 93 der Einrichtung 3, die durch Schrauben 94 zusammengehalten werden, gehalten. Ein Rohrstück 95 wird in eine Öffnung der oberen Platte 92 eingeschraubt und fluchtet mit einem Loch 96 in der oberen Platte 90 und ist gegenüber der Platte 90 durch eine Ringdichtung (z. B. O-Ring) abgedichtet. Das Rohrstück 95 dient als Einlass für das zu kühlende Medium (Pfeil 97). In die untere Platte 2 ist ebenfalls ein Rohrstück 95 eingeschraubt, das mit einer Öffnung 96 in der unteren Platte kommuniziert und gegenüber der Platte 90 durch eine Ringdichtung (z. B. O-Ring) abgedichtet ist. Durch das Rohrstück 95 kann das Medium, nachdem es den Raum zwischen den Platten 90 durchströmt hat, aus der Einrichtung 3 wieder austreten (Pfeil 98). Den Platten sind beidseitig Peltierelemente 100 so zugeordnet, dass vom Medium entzogene Wärme über die Peltierelemente an einen Kühlkörper 101, der an der Oberseite und an der Unterseite angeordnet ist, abgegeben wird. Die Kühlelemente 101 weisen jeweils einen Einlass 102 und einen Auslass 103 auf, so dass sie von einem Kühlmedium durchströmt werden können.

In Fig. 9 ist noch angedeutet, dass die Peltierelemente durch wärmeleitenden Kleber 104 in gut wärmeleitende Verbindung zu den Kühlkörpern 101 gebracht werden.

Die in Fig. 9 gezeigte Vorrichtung kann nach Umpolen der Peltierelemente 100 grundsätzlich auch zum Erwärmen eines durch die Einrichtung 3 strömenden Medium eingesetzt werden.

Eine Einrichtung 4 zur Durchflussmengenregelung wird nachstehend an Hand von Fig. 10 erläutert:
Die Einrichtung 4 zum Regeln des Durchflusses eines Medium umfasst eine Membran 110, die auf einer Seite einen nadelförmigen, sich verjüngenden Vorsprung aufweist, dessen Abstand zum Ventilsitz 111 der mit einem Körper 112 einteilig verbunden ist, mit Hilfe einer Stellvorrichtung 113, 114 verändert werden kann. Die Stellvorrichtung umfasst vorzugsweise einen Schrittmotor 113, dessen Spindel 114 einen Antrieb für das Membran 110 darstellt. Die Spindel 114 dreht sich nicht und wird mittels einer im Motor 113 eingebauten, sich drehenden Hülse nur linear bewegt. In den Eingang 115 wird Medium eingeleitet und tritt über den Ausgang 116 wieder aus. Die Körper 117 und 118 dienen lediglich zum Positionieren des Schrittmotors 113 und zum Abdichten der Membran 110, wozu nicht gezeigte Verschraubungen vorgesehen sind. Ein Sensor 119 erfasst den Abstand der Membran 110 bzw. deren Spiel vom Ventilsitz 111, welche Daten der Regelung zugeführt werden.

Eine in Fig. 11 schematisch dargestellte Ausführungsform der Durchflussmanipulation 4 ermittelt den Durchfluss mit Hilfe eines Durchfluss-Sensors 121 (beispielsweise ein Ultraschalldurchfluss-Sensor). Die dabei erfassten Werte werden über eine Signalleitung 112 einer Steuerung 123 zugeführt, welche über eine weitere Steuerleitung 124 den Aktor 113, 114 (Schrittmotor) des Durchflussreglers 129 betreibt, der wiederum seine aktuelle Lage durch eine Positionskontrolle über eine Kontrollleitung 125 an die Steuerung weitergibt. Der Durchfluss des Medium über Einlass 127 und durch Auslass 128 kann über eine Hauptsteuerleitung 126 von außen vorgegeben werden.

Um ein rasches Regeln der Temperatur des Medium, bezogen auf die Position der Düse 11 relativ zum Wafer 8, zu erlauben, ist es erforderlich ein vorher bekanntes zeitlich-, örtliches Temperaturprofil zu erstellen, damit die jeweils benötigte Temperatur des Medium eingehalten werden kann. Hierzu wird vorteilhaft eine Kühleinrichtung verwendet, die örtliche Temperaturdifferenzen ausgleicht und dabei die aktuelle Einstellung des Systems und des zu behandelnden Medium ist berücksichtigt, um etwaige Störfaktoren, Wärmesenken usw. zu vermeiden.

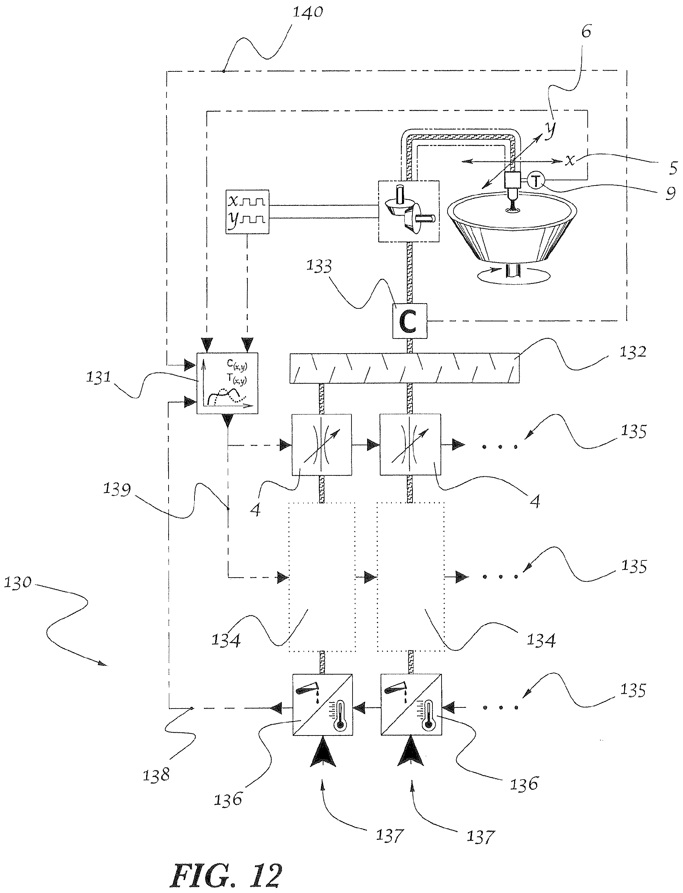

Die in Fig. 12 dargestellte, abgeänderte Ausführungsform einer erfindungsgemäßen Vorrichtung 130 ist eine Erweiterung der Vorrichtung 1 gemäß Fig. 1. Auch die Vorrichtung 130 umfasst Einrichtungen 134 zum Regeln der Temperatur und Einrichtungen 4 zum Regeln der Durchflussmenge des durch die Düse 11 auf den Wafer 8 aufgebrachtem Behandlungs-Medium
(Behandlungsflüssigkeit).

Zusätzlich umfasst die Vorrichtung 130 gemäß Fig. 12 Einrichtungen, mit welchen die Konzentration des Behandlungs-Medium (Ätzflüssigkeit) in Abhängigkeit von der Lage der Düse 11 und damit des Ortes 7, in dem Behandlungs-Medium auf den Wafer 8 aufgebracht wird, geändert werden kann.

Die hierzu vorgesehene Vorrichtung umfasst einen Sensor 133, der die Konzentration des Behandlungs-Medium erfasst. Beispielsweise ist der Konzentrationssensor 133 ein gängiges pH-Messgerät oder ein Spektrometer, mit dem Konzentration der jeweils verwendeten Behandlungsflüssigkeit bestimmt werden kann.

Im Einzelnen arbeitet die Vorrichtung 130 beim Einstellen der Konzentration in Abhängigkeit von der Düse 11 wie folgt:
Die Komponenten des Behandlungs-Medium werden über Leitungen 137 zugeführt und die definierten Konzentrations- und Temperaturwerte in Mediumquellen 136 über eine Steuerleitung 138 an die Steuerung/Regelung 131 weitergegeben. Ein Software-Algorithmus setzt die über die Leitungen 138 zugeführten Temperaturwerte, die über die Leitung 140 zugeführten Konzentrationswerte und die Werte der Temperatur, die vom Temperatursensor 9 erfasst werden, in Steuersignale um. Diese Steuersignale werden über Steuerleitungen 139 an die Komponenten 134 zum Regeln der Temperatur 134 und die Vorrichtung 4 zum Regeln der Durchflussmenge weitergegeben. Die Medienströme werden einer Mischvorrichtung 132 zugeführt, die insbesondere als statischer Mischer ausgebildet ist, und miteinander gemischt, wobei bei Verwenden eines statischen Mischers ein schnelles Durchmischen zum Erreichen der gewünschten Temperatur und/oder Konzentration bei der vorgegebenen Menge erreicht werden kann.

Die in Fig. 12 neben den Durchflussmengenreglern 4, den Reglern für die Temperatur 134 und den Medienquellen 136 eingezeichneten Punkte 135 deuten an, dass auch mehr als zwei dieser Komponenten vorgesehen sein können.

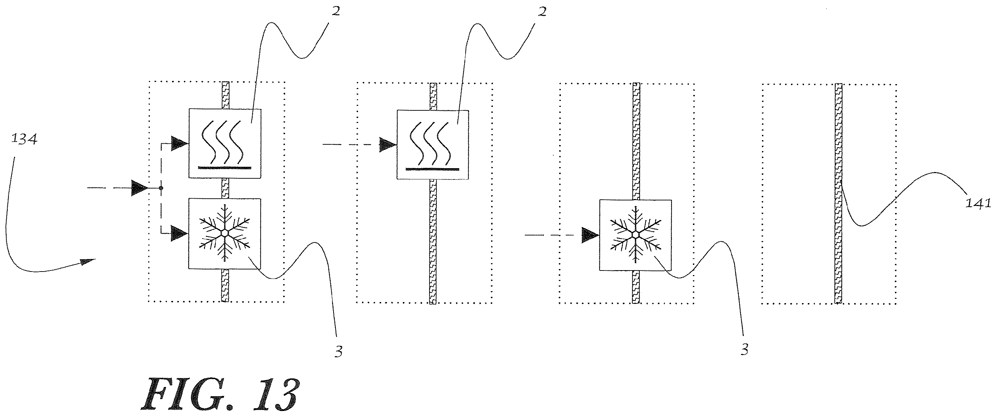

In Fig. 13 sind verschiedene Kombinationsmöglichkeiten von Einrichtungen zum Erwärmen 2 und Einrichtungen 3 zum Kühlen angedeutet. Weitere Möglichkeiten des Kombinierens der in Fig. 13 aufgezeigten Varianten sind die Einrichtungen 134 zum Einstellen der Temperatur durch Erwärmen und Kühlen des Medium sind denkbar, wobei auch die Variante ohne Einrichtung zum Regeln der Temperatur 134 bei 141 angedeutet ist. Wenn diese Variante, die bei 141 angedeutet ist, umgesetzt wird, kann das Einstellen der Temperatur analog zum Einstellen der Konzentration über Durchflussregler erfolgen, ohne gesonderte Einrichtungen zum Heizen und zum Kühlen, wenn die Temperaturen in den Medienquellen 136 der Mediumtröme 137 hinreichend verschieden hoch sind.

## Patentansprüche

1. Verfahren zum Behandeln von Gegenständen (8) mit einem Medium, insbesondere einer Flüssigkeit, das die folgende Schritte umfasst:
- Aufbringen des Mediums auf die zu behandelnde Fläche des auf einer Halterung (19) aufgelegten Gegenstandes (8) mit Hilfe einer Aufbringeeinrichtung mit einer Düse (11), der mit einer Leitung (17) das Medium zugeführt wird und die über eine Einrichtung (13) starr mit Aktoren (12) verbunden ist und über die Aktoren (12) relativ zu dem zu behandelnden Gegenstand (8) über die zu behandelnde Fläche des Gegenstandes (8) bewegt wird, wobei die Lage der Düse (11) durch Inkrementalgeber (14 ), die den Aktoren (12) zugeordnet sind, erfasst wird, Regeln von Eigenschaften des auf den zu behandelnden Gegenstand (8) aufzubringenden Mediums in Abhängigkeit von der Lage der Düse (11) relativ zu der zu behandelnden Fläche des Gegenstandes (8),
- Regeln der Temperatur des auf den zu behandelnden Gegenstand (8) aufzubringenden Mediums mit Hilfe des Regelkreises (10), wobei die Temperatur mit Hilfe eines Temperatursensors (9) erfasst wird, welcher der Leitung (17) unmittelbar vor der Düse (11) zugeordnet ist und an den Regelkreis (10) Daten betreffend die von ihm erfasste Temperatur des Mediums abgibt,
- Aufgeben der von den Inkrementalgebern (14) erfassten Lage der Düse (11) und der vom Temperatursensor (9) erfassten Temperatur des Mediums an einem Regelkreis (10) und Regeln der Temperatur des Mediums und/oder der Menge an Medium, die der Düse (11) in der Zeiteinheit zugeführt wird mit dem Regelkreis (10), wofür der Leitung (17) für das Medium eine Einrichtung (4) zum Regeln der in der Zeiteinheit durch die Leitung (17) strömende Menge an Medium und Einrichtungen (2, 3) zum Erwärmen und Kühlen des Mediums zugeordnet sind, welche Einrichtungen (2, 3, 4) mit dem Regelkreis (10) funktionell verbunden sind.

2. Verfahren nach Anspruch 1, wobei die Konzentration des auf den zu behandelnden Gegenstand (8) aufzubringenden Mediums geregelt wird.

3. Verfahren nach Anspruch 1 oder 2, wobei ein Halbleiter-Wafer (8) behandelt wird.

4. Verfahren nach Anspruch 3, wobei der Halbleiter-Wafer (8) geätzt wird.

5. Verfahren nach Anspruch 3, wobei der Halbleiter-Wafer (8) gereinigt wird.

6. Verfahren nach einem der Ansprüche 1 bis 5, wobei der zu behandelnde Gegenstand (8) während des Behandelns in Drehung (20) versetzt wird.

7. Verfahren nach einem der Ansprüche 1 bis 6, wobei die Temperatur des Mediums unmittelbar vor dem Aufbringen auf den zu behandelnden Gegenstand (8), insbesondere unmittelbar vor seinem Austritt aus der Düse (11) der Aufbringeeinrichtung, erfasst wird.

8. Verfahren nach einem der Ansprüche 1 bis 7, wobei das Medium, insbesondere die Flüssigkeit, erwärmt oder gekühlt wird.

9. Verfahren nach Anspruch 8, wobei zum Regeln der Temperatur Komponenten des auf den zu behandelnden Gegenstand (8) aufzubringenden Mediums, insbesondere der Flüssigkeit, die voneinander verschiedene Temperaturen haben, gemischt werden.

10. Verfahren nach einem der Ansprüche 1 bis 9, wobei zum Regeln der Konzentration komponenten des auf den zu behandelnden Gegenstand (8) aufzubringenden Mediums, insbesondere der Flüssigkeit, die voneinander verschiedene Konzentrationen haben, gemischt werden.

11. Verfahren nach einem der Ansprüche 1 bis 10 , wobei der Regelkreis (10) die Konzentration des Mediums regelt.

12. Vorrichtung zum Durchführen des Verfahrens nach einem der Ansprüche 1 bis 11 mit einer Halterung (19) für den zu behandelnden Gegenstand (8), mit einer Aufbringeeinrichtung mit einer Düse (11) zum Aufbringen des Mediums auf die zu behandelnde Fläche des zu behandelnden Gegenstand (8), zu welcher Düse (11) eine Leitung (17) für das Medium führt , und die über eine Einrichtung (13) starr mit Aktoren (12) zum Bewegen der Düse (11) relativ zu den zu behandelnden Gegenstand (8) verbunden ist, wobei
- wenigstens ein Sensor zum Erfassen von wenigstens einer Eigenschaft des Mediums angeordnet ist,
- wenigstens einen Inkrementalgeber (14), der zum Erfassen der Lage der Düse (11) den Aktoren (12) zugeordnet ist,
- ein Regelkreis (10) funktionell mit wenigstens einem Sensor und mit dem Inkrementalgeber (14) verbunden ist,
- eine der Leitung (17) für das Medium zugeordnete Einrichtung (4) zum Regeln der in der Zeiteinheit durch die Leitung (17) strömende Menge an Medium angeordnet ist, welche Einrichtung (4) mit dem Regelkreis (10) funktionell verbunden ist,
- Einrichtungen (2, 3) zum Erwärmen und Kühlen des Mediums der Leitung (17) für das Medium zugeordnet sind, welche Einrichtungen (2, 3) mit dem Regelkreis (10) funktionell verbunden sind,
- ein Temperatursensor (9) angeordnet ist, welcher der Leitung (17) unmittelbar vor der Düse (11) zugeordnet ist und die Temperatur des Mediums erfasst, sowie diese an den Regelkreis (10) weitergibt.

13. Vorrichtung nach Anspruch 12, wobei die Halterung (19) für den zu behandelnden Gegenstand (8) ein Träger nach Art eines Trägers (19) für Halbleiter-Wafer (8) ("chuck") ist, dem ein Antrieb zum Drehen (20) der Halterung (19) zugeordnet ist.

14. Vorrichtung nach Anspruch 12 oder 13, wobei ein Sensor (133) zum Erfassen der Konzentration des Mediums, insbesondere der Flüssigkeit, vorgesehen ist.

15. Vorrichtung nach einem der Ansprüche 12 bis 14, wobei eine Mischvorrichtung (132) zum Mischen von Teilströmen des Mediums, welche Teil ströme voneinander unterschiedliche Temperaturen und/oder Konzentrationen aufweisen, vorgesehen ist.

16. Vorrichtung nach einem der Ansprüche 12 bis 15, wobei die Einrichtung (2) zum Erwärmen des Mediums, insbesondere der Flüssigkeit, eine das Medium durch Konvektion erwärmende Einrichtung, die auf Induktionsbasis arbeitet, ist.

17. Vorrichtung nach einem der Ansprüche 12 bis 16, wobei die Einrichtung (3) zum Kühlen des Mediums wenigstens ein Peltier-Element (1 00) umfasst.

18. Vorrichtung nach einem der Ansprüche 12 bis 17, wobei
- ein Gehäuse (30), in dem ein Strömungskanal (33, 34, 35) für das Medium, dessen Temperatur zu erfassen ist, vorgesehen ist,
- der Strömungskanal (33) im Bereich eines Temperatur-Sensors in zwei Teilkanäle (34, 35) aufgeteilt ist, die sich nach dem Vorbei strömen am Temperatur-Sensor (42) wieder vereinigen und
- der Temperatur-Sensor (42) auf einem scheibenförmigen Körper (36) im wäremleitenden Kontakt angeordnet ist.

19. Vorrichtung nach einem der Ansprüche 12 bis 18, wobei im Strömungskanal des Temperatursensors ein Turbulenzen in dem durchströmenden Medium erzeugendes Hindernis (51) vorgesehen ist, wobei das Hindernis (51), bezogen auf die Strömungsrichtung des Mediums, nach der Scheibe (36) , auf welcher der Temperatursensor (42) angeordnet ist, vorgesehen ist.

## Claims

1. Method for treating objects (8) with a medium, in particular a liquid, comprising the following steps of:
- applying the medium to the surface to be treated of the object (8) placed on a holder (19) with the aid of an application device with a nozzle (11), to which the medium is supplied by a line (17) and which is rigidly connected to actuators (12) via a device (13) and is moved relative to the object (8) to be treated over the surface of the object (8) to be treated via the actuators (12), wherein the position of the nozzle (11) is detected by incremental encoders (14) which are assigned to the actuators (12), regulating properties of the medium to be applied to the object (8) to be treated depending on the position of the nozzle (11) relative to the surface of the object (8) to be treated,
- regulating the temperature of the medium to be applied to the object (8) to be treated with the aid of the control circuit (10), wherein the temperature is detected with the aid of a temperature sensor (9) which is assigned to the line (17) immediately upstream of the nozzle (11) and supplies the control circuit (10) with data relating to the temperature of the medium detected by it,
- feeding the position of the nozzle (11) detected by the incremental encoders (14) and the temperature of the medium detected by the temperature sensor (9) to a control circuit (10) and regulating the temperature of the medium and/or the quantity of medium fed to the nozzle (11) in the unit of time with the control circuit (10), for which purpose a device (4) for regulating the quantity of medium flowing through the line (17) in the unit of time and devices (2, 3) for heating and cooling the medium are assigned to the line (17) for the medium, which devices (2, 3, 4) are functionally connected to the control circuit (10).

2. Method according to claim 1, wherein the concentration of the medium to be applied to the object (8) to be treated is regulated.

3. Method according to claim 1 or 2, wherein a semiconductor wafer (8) is treated.

4. Method according to claim 3, wherein the semiconductor wafer (8) is etched.

5. Method according to claim 3, wherein the semiconductor wafer (8) is cleaned.

6. Method according to one of claims 1 to 5, wherein the object (8) to be treated is rotated (20) during the treatment.

7. Method according to one of claims 1 to 6, wherein the temperature of the medium is detected immediately before it is applied to the object (8) to be treated, in particular immediately before it emerges from the nozzle (11) of the application device.

8. Method according to one of claims 1 to 7, wherein the medium, in particular the liquid, is heated or cooled.

9. Method according to claim 8, wherein components of the medium to be applied to the object (8) to be treated, in particular the liquid, which have different temperatures from one another, are mixed to regulate the temperature.

10. Method according to one of claims 1 to 9, wherein components of the medium to be applied to the object (8) to be treated, in particular the liquid, which have different temperatures from one another, are mixed to regulate the concentration.

11. Method according to one of claims 1 to 10, wherein the control circuit (10) regulates the concentration of the medium.

12. Device for carrying out the method according to one of claims 1 to 11, having a holder (19) for the object (8) to be treated, having an application device with a nozzle (11) for applying the medium to the surface of the object (8) to be treated, to which nozzle (11) a line (17) for the medium leads and which is rigidly connected via a device (13) to actuators (12) for moving the nozzle (11) relative to the object (8) to be treated, wherein
- at least one sensor is arranged to detect at least one property of the medium,
- at least one incremental encoder (14), which is assigned to the actuators (12) for detecting the position of the nozzle (11),
- a control circuit (10) is functionally connected to at least one sensor and to the incremental encoder (14),
- a device (4) associated with the line (17) for the medium is arranged for regulating the quantity of medium flowing through the line (17) in the unit of time, which device (4) is functionally connected to the control circuit (10),
- devices (2, 3) for heating and cooling the medium are assigned to the line (17) for the medium, which devices (2, 3) are functionally connected to the control circuit (10),
- a temperature sensor (9) is arranged, which is assigned to the line (17) directly upstream of the nozzle (11) and detects the temperature of the medium and transmits it to the control circuit (10).

13. Device according to claim 12, wherein the holder (19) for the object (8) to be treated is a carrier of the type of a carrier (19) for semiconductor wafers (8) ("chuck"), to which a drive for rotating (20) the holder (19) is associated.

14. Device according to claim 12 or 13, wherein a sensor (133) is provided for detecting the concentration of the medium, in particular the liquid.

15. Device according to one of claims 12 to 14, wherein a mixing device (132) is provided for mixing partial streams of the medium, which partial streams have different temperatures and/or concentrations from each other.

16. Device according to one of claims 12 to 15, wherein the device (2) for heating the medium, in particular the liquid, is a device which heats the medium by convection and which operates on an induction basis.

17. Device according to one of claims 12 to 16, wherein the device (3) for cooling the medium comprises at least one Peltier element (100).

18. Device according to one of claims 12 to 17, wherein
- a housing (30) in which a flow channel (33, 34, 35) is provided for the medium whose temperature is to be detected,
- the flow channel (33) is divided into two partial channels (34, 35) in the region of a temperature sensor, which reunite after flowing past the temperature sensor (42), and
- the temperature sensor (42) is arranged on a disk-shaped body (36) in the heat-conducting contact.

19. Device according to one of claims 12 to 18, wherein an obstacle (51) generating turbulence in the medium flowing through is provided in the flow channel of the temperature sensor, wherein the obstacle (51), with respect to the flow direction of the medium, is provided after the disk (36) on which the temperature sensor (42) is arranged.

## Revendications

1. Procédé de traitement d'objets (8) avec un agent, en particulier un liquide, qui comprend les étapes suivantes :
- Application de l'agent sur la surface à traiter de l'objet (8) posé sur un support (19) à l'aide d'un appareil d'application comportant une buse (11) à laquelle l'agent est amené par une conduite (17) et qui est reliée rigidement à des actionneurs (12) par un appareil (13) et qui est déplacée par les actionneurs (12) par rapport à l'objet (8) à traiter sur la surface à traiter de l'objet (8), la position de la buse (11) étant détectée par des capteurs incrémentaux (14) associés aux actionneurs (12), régulation de propriétés de l'agent à appliquer sur l'objet (8) à traiter en fonction de la position de la buse (11) par rapport à la surface à traiter de l'objet (8),
- Régulation de la température de l'agent à appliquer sur l'objet (8) à traiter à l'aide du circuit de régulation (10), la température étant détectée à l'aide d'un capteur de température (9) qui est associé à la conduite (17) directement en amont de la buse (11) et qui fournit au circuit de régulation (10) des données concernant la température de l'agent qu'il a détectée,
- Envoi de la position de la buse (11) détectée par les capteurs incrémentaux (14) et la température de l'agent détectée par le capteur de température (9) à un circuit de régulation (10) et régulation de la température de l'agent et/ou de la quantité d'agent qui est amenée à la buse (11) dans l'unité de temps avec le circuit de régulation (10), pour lequel sont associés à la conduite (17) pour l'agent un appareil (4) de régulation de la quantité d'agent s'écoulant dans l'unité de temps à travers la conduite (17) et des appareils (2, 3) de chauffage et refroidissement de l'agent, lesquels appareils (2, 3, 4) sont reliés de manière fonctionnelle au circuit de régulation (10).

2. Procédé selon la revendication 1, dans lequel la concentration de l'agent à appliquer sur l'objet (8) à traiter est régulée.

3. Procédé selon la revendication 1 ou 2, dans lequel une tranche de semi-conducteur (8) est traitée.

4. Procédé selon la revendication 3, dans lequel la tranche de semi-conducteur (8) est décapée.

5. Procédé selon la revendication 3, dans lequel la tranche de semi-conducteur (8) est nettoyée.

6. Procédé selon l'une quelconque des revendications 1 à 5, dans lequel l'objet (8) à traiter est entraîné en rotation (20) pendant le traitement.

7. Procédé selon l'une quelconque des revendications 1 à 6, dans lequel la température de l'agent est détectée juste avant son application sur l'objet (8) à traiter, en particulier juste avant sa sortie de la buse (11) de l'appareil d'application.

8. Procédé selon l'une quelconque des revendications 1 à 7, dans lequel l'agent, en particulier le liquide, est chauffé ou refroidi.

9. Procédé selon la revendication 8, dans lequel, pour réguler la température, sont mélangés des composants de l'agent à appliquer sur l'objet (8) à traiter, en particulier du liquide, qui ont des températures différentes les uns des autres.

10. Procédé selon l'une quelconque des revendications 1 à 9, dans lequel, pour réguler la concentration, sont mélangés des composants de l'agent à appliquer sur l'objet (8) à traiter, en particulier du liquide, qui ont des concentrations différentes les uns des autres.

11. Procédé selon l'une quelconque des revendications 1 à 10, dans lequel le circuit de régulation (10) régule la concentration de l'agent.

12. Dispositif de mise en œuvre du procédé selon l'une quelconque des revendications 1 à 11, avec un support (19) pour l'objet (8) à traiter, avec un appareil d'application avec une buse (11) d'application de l'agent sur la surface à traiter de l'objet (8) à traiter, buse (11) à laquelle mène une conduite (17) pour l'agent, et qui est reliée rigidement par un appareil (13) à des actionneurs (12) de déplacement de la buse (11) par rapport à l'objet (8) à traiter,
- au moins un capteur étant disposé pour détecter au moins une propriété de l'agent,
- au moins un codeur incrémental (14) étant associé aux actionneurs (12) pour détecter la position de la buse (11),
- un circuit de régulation (10) étant relié de manière fonctionnelle à au moins un capteur et au codeur incrémental (14),
- un appareil (4) de régulation de la quantité d'agent s'écoulant dans l'unité de temps à travers la conduite (17) associé à la conduite (17) pour l'agent étant disposé, lequel appareil (4) est relié de manière fonctionnelle au circuit de régulation (10),
- des appareils (2, 3) de chauffage et refroidissement de l'agent étant associés à la conduite (17) pour l'agent, lesquels appareils (2, 3) sont reliés de manière fonctionnelle au circuit de régulation (10),
- un capteur de température (9) étant disposé, lequel est associé à la conduite (17) directement en amont de la buse (11) et détecte la température de l'agent, ainsi que la transmet au circuit de régulation (10).

13. Dispositif selon la revendication 12, dans lequel le support (19) pour l'objet (8) à traiter est un support du type porteur (19) pour tranche de semi-conducteur (8) (« chuck »), auquel est associé un entraînement pour la rotation (20) du support (19).

14. Dispositif selon la revendication 12 ou 13, dans lequel il est prévu un capteur (133) de détection de la concentration de l'agent, en particulier du liquide.

15. Dispositif selon l'une quelconque des revendications 12 à 14, dans lequel il est prévu un dispositif de mélange (132) pour mélanger des écoulements partiels de l'agent, lesquels écoulements partiels présentent des températures et/ou des concentrations différentes les unes des autres.

16. Dispositif selon l'une quelconque des revendications 12 à 15, dans lequel l'appareil (2) de chauffage de l'agent, en particulier du liquide, est un appareil de chauffage de l'agent par convection fonctionnant par induction.

17. Dispositif selon l'une quelconque des revendications 12 à 16, dans lequel l'appareil (3) de refroidissement de l'agent comprend au moins un élément Peltier (100).

18. Dispositif selon l'une quelconque des revendications 12 à 17, dans lequel
- il est prévu un boîtier (30) dans lequel est disposé un canal d'écoulement (33, 34, 35) pour l'agent dont la température est à détecter,
- le canal d'écoulement (33) est divisé, dans la zone d'un capteur de température, en deux canaux partiels (34, 35) qui se réunissent à nouveau après avoir passé le capteur de température (42) et
- le capteur de température (42) est disposé sur un corps en forme de disque (36) en contact de conduction thermique.

19. Dispositif selon l'une quelconque des revendications 12 à 18, dans lequel il est prévu dans le canal d'écoulement du capteur de température un obstacle (51) générant des turbulences dans l'agent qui le traverse, l'obstacle (51) étant prévu, par rapport au sens d'écoulement de l'agent, en aval du disque (36) sur lequel est disposé le capteur de température (42).
